# FASCICULE DE BREVET EUROPEEN

(11) **EP 0 716 507 B1**
(45) Date de publication et mention de la délivrance du brevet: **12.10.2005**
(21) Numéro de dépôt: 95402735.5
(22) Date de dépôt: 05.12.1995
(51) Int. Cl.: H03K 17/042, H03K 17/081, H03K 3/57, H02M 1/088

(54) **Dispositif de commande d'un commutateur à grille isolée, de fort courant, et commutateur d'impulsions comportant un tel dispositif**
Ansteuereinrichtung eines Hochstromschalters mit isoliertem Gate und Impulsschalter unter Verwendung derselben
Control circuit for a high current switch having an isolated gate and impulse switch using such a circuit

(30) Priorité: 07.12.1994 FR 9414704
(43) Date de publication de la demande: 12.06.1996
(73) Titulaire: COMMISSARIAT A L'ENERGIE ATOMIQUE, 75015 Paris (FR)
(72) Inventeur: Chatroux, Daniel, F-26200 Montelimar (FR); Guyon, Yves, F-84840 Lapalud (FR); Guidini, Rodolphe, F-45500 Gien (FR)
(74) Mandataire: Poulin, Gérard

(56) Documents cités:
- EP-A- 0 431 846
- GB-A- 2 164 513
- PATENT ABSTRACTS OF JAPAN vol. 015 no. 359 (E-1110) ,11 Septembre 1991 & JP-A-03 141720 (HITACHI LTD) 17 Juin 1991,
- PATENT ABSTRACTS OF JAPAN vol. 16 no. 403 (E-1254) ,26 Août 1992 & JP-A-04 133512 (MITSUBISHI ELECTRIC CORP) 7 Mai 1992,
- PATENT ABSTRACTS OF JAPAN vol. 15 no. 135 (E-1052) ,4 Avril 1991 & JP-A-03 016415 (MITSUBISHI ELECTRIC CORP) 24 Janvier 1991,
- PATENT ABSTRACTS OF JAPAN vol. 16 no. 22 (E-1156) ,20 Janvier 1992 & JP-A-03 237813 (MITSUBISHI ELECTRIC CORP) 23 Octobre 1991,
- MEASUREMENT SCIENCE &TECHNOLOGY, vol. 3, no. 8, Août 1992 BRISTOL, GB, pages 775-777, R. J. BAKER ET AL: 'A 500 V nanosecond pulse generator using cascode-connected power MOSFETS'

## Description

### Domaine technique

La présente invention se rapporte à un dispositif de commande d'un commutateur à grille isolée pour la commutation d'impulsions de fort courant, éventuellement de haute tension et de faible durée. On entend par haute tension et fort courant, une tension allant de 1 KV à quelques dizaines de KV et un courant allant de quelques centaines à quelques milliers d'ampères. Par faibles durées, on entend des durées de l'ordre d'une dizaine à quelques centaines de nanosecondes.

L'invention s'applique en particulier à la réalisation d'interrupteurs dans lesquels ces dispositifs de commande permettent la mise en conduction d'un nombre important d'étages montés en série et constitués d'un grand nombre de transistors à grille isolée branchés en parallèle pour la commutation d'impulsions de haute tension, de fort courant et de faible durée. L'invention concerne exclusivement la commande de commutateurs commandés en tension, c'est-à-dire qui comportent des transistors ou organes de commutation à grille isolée.

### Etat de la technique antérieure

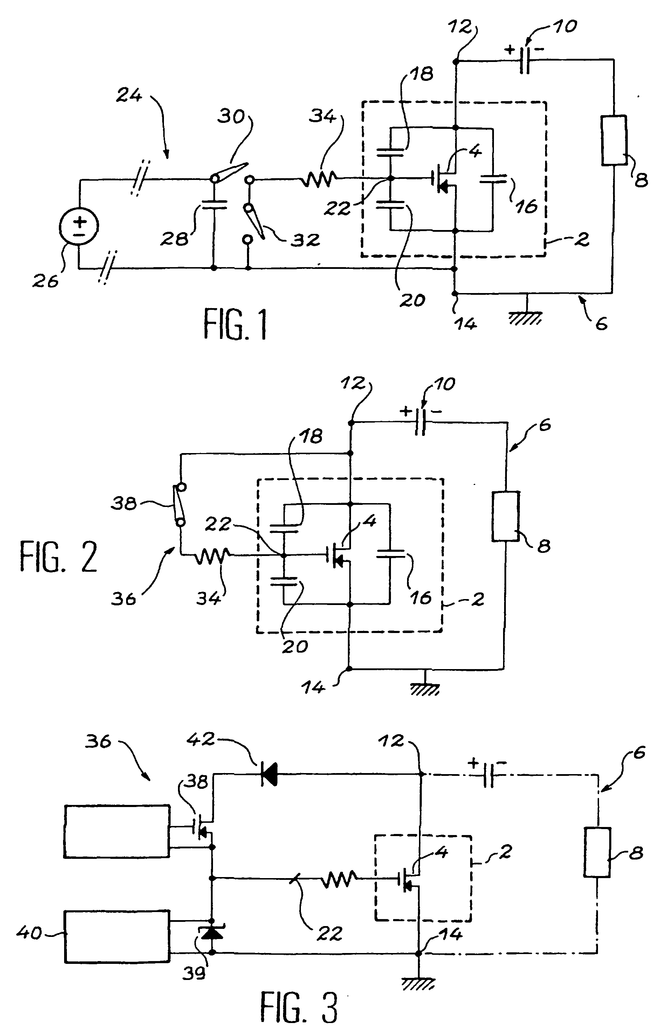

Les dispositifs de commande de commutateurs d'impulsions comportent de façon connue d'une part, des moyens de mise en conduction du commutateur et d'autre part, des moyens dits de blocage qui mettent fin à la conduction du commutateur. Un tel dispositif est décrit dans le document GB-A-2 164 513. On peut se reporter à ce sujet à la figure 1. Le montage représenté schématiquement à la figure 1 comporte un commutateur à grille isolée 2. Ce commutateur est équipé par exemple d'un transistor de type MOS (Métal-Oxyde-Semiconducteur) avec la référence 4. Le commutateur 2 a la fonction d'un interrupteur pour faire circuler un courant dans un circuit 6 qui comporte une charge 8 et un réservoir d'énergie électrique 10 formé par un condensateur. Ce montage est prévu pour faire passer dans la charge 8 des impulsions brèves de fort courant. Ainsi, lorsque le commutateur 2 est mis en conduction et se comporte comme un interrupteur fermé, des charges accumulées dans le condensateur 10 viennent s'écouler rapidement dans la charge 8. Le condensateur 10 et la charge 8 sont montés en série dans un circuit qui est relié à des bornes 12 et 14 du commutateur 2, ces bornes correspondant respectivement au drain et à la source du transistor 4.

Sur la figure 1, sont représentées également des capacités internes du commutateur 2. Une capacité 16 relie la source et le drain du transistor 4. Des capacités 18 et 20 relient respectivement le drain et la source à la grille 22 du transistor 4 supposé idéal. Un dispositif de commande 24 du commutateur 2 comporte d'une part des moyens de mise en conduction composés essentiellement d'une source de tension 26, d'un condensateur 28 et d'un interrupteur 30, et d'autre part, des moyens dits de blocage comportant un interrupteur 32. Les moyens de mise en conduction et les moyens de blocage sont reliés en parallèle sur la grille, par l'intermédiaire d'une résistance de grille 34, et sur la source du commutateur 2. Lorsque l'interrupteur 30 se ferme, la source de tension 26 en parallèle avec le condensateur 28 permet de faire circuler un courant dans la résistance 34 qui vient charger le condensateur de grille 20, ce qui provoque la mise en conduction du transistor 4. Les condensateurs 18 et 16 se déchargent alors dans le transistor 4. A l'inverse, lorsque l'interrupteur 30 est ouvert et l'interrupteur 32 fermé, le condensateur 20 se décharge à travers la résistance 34. Le transistor 4 passe alors dans un état bloqué où il n'est plus conducteur.

Un tel dispositif montre rapidement ses limites dans des applications où l'on souhaite fournir des impulsions de fort courant et de courte durée. La mise en conduction rapide d'un transistor à grille isolée nécessite la fourniture d'un fort courant de commande pour charger la grille. A titre d'exemple, pour la mise en conduction d'un transistor du type IRF 840, après un temps de réponse de 20 ns, il faut fournir une impulsion de courant de commande à la grille de 3 A. Ainsi, dans un commutateur susceptible de fournir des impulsions brèves de fort courant et de haute tension, qui comporte par exemple une trentaine de ces transistors mis en parallèle, il faut fournir un courant de commande de 90 A. Ainsi, lorsque l'on souhaite commander plusieurs transistors à grille isolée en parallèle, le dispositif de commande nécessite une source de tension auxiliaire et un interrupteur de commande à fort courant et de faible inductance parasite.

Le brevet JP 3 141 720 décrit un dispositif de commande d'un commutateur à grille isolée destiné à être connecté aux bornes d'une charge, avec des moyens de blocage du commutateur et des moyens de mise en conduction du commutateur. Les moyens de mise en conduction sont en deux parties dont l'une comprend un interrupteur permettant de dériver transitoirement du courant de la charge sans rendre le commutateur pleinement conducteur et dont l'autre, incluant une alimentation, finit la mise en conduction.

En se reportant encore à l'exemple de la figure 1, une telle source de tension auxiliaire est réalisée par le condensateur 28. La source 26 vient charger le condensateur 28, puis, quand l'interrupteur 30 est fermé, le condensateur 28 fournit le courant de grille nécessaire à la commande du ou des transistors.

Lorsque le nombre de transistors est important, il est nécessaire de disposer d'un réservoir d'énergie suffisant et ayant une inductance très faible. Ceci impose l'usage de batteries de condensateurs de forte capacité ainsi que des pistes conductrices de distribution de l'énergie dimensionnées en conséquence. Ces composants supplémentaires sont d'un coût élevé et ne permettent pas d'obtenir un dispositif dont la compacité est compatible avec une réalisation intégrée.

Un autre problème qui se pose pour la commande d'un grand nombre de transistors reliés en parallèle, est celui d'une bonne répartition du courant de commande entre les différents transistors à grille isolée. Les transistors doivent en effet être commandés simultanément. Le dispositif de commande doit donc être capable de fournir des courants de grille identiques en même temps, c'est-à-dire avec une dispersion de temps de l'ordre de la nanoseconde. Pour permettre un établissement rapide d'un courant de grille, les inductances de câblage en série avec chacune des grilles de chaque transistor doivent être minimisées. Par exemple, il est souhaitable de ne pas dépasser une valeur de 30 nH pour l'inductance de câblage de chaque composant.

Dans le cas de l'exemple précédent de la mise en parallèle de trente transistors du type IRF 840, il est très difficile de générer un courant total de grille de 90 A et de le distribuer à l'ensemble des grilles. En effet, l'inductance équivalente de l'ensemble des transistors doit être inférieure à 1 nH pour avoir une inductance équivalente par grille de 30 nH. Une solution pourrait être envisagée en implantant les différents transistors à grille isolée de manière circulaire, le dispositif de commande étant alors placé au centre. Une telle méthode connue pour les transistors bipolaires permet une circulation radiale des courants de commande et de puissance avec une inductance équivalente faible. Une telle structure n'est cependant pas adaptée pour la mise en série et en parallèle d'un grand nombre de transistors à grille isolée car les interconnexions entre les différents composants disposés circulairement sont délicates à mettre en oeuvre et le volume de l'ensemble devient très important.

La présente invention a donc comme objet de proposer un dispositif de commande susceptible de commander un commutateur qui comporte un grand nombre de transistors mis en série ou en parallèle.

Un autre objet de la présente invention est de proposer un commutateur capable de commuter des impulsions de fort courant et de faible durée et qui ne présente pas les inconvénients mentionnés ci-dessus.

Un autre objectif encore est de fournir un commutateur qui soit à la fois fiable, compact et d'une réalisation simple.

### Exposé de l'invention

Pour atteindre ces objectifs, l'invention concerne plus particulièrement un dispositif de commande d'un commutateur à grille isolée pour la commutation d'impulsions de fort courant, tel que défini dans la revendication 1.

Ainsi, le courant de commande est dérivé par le circuit de charge qui comporte de toute façon un important réservoir d'énergie électrique pour fournir le courant de charge.

L'écrêteur peut être une diode Zener branchée à l'entrée du commutateur entre l'électrode de commande et la seconde électrode principale. Sa fonction est de limiter la tension de l'électrode de commande, c'est-à-dire la tension entre l'électrode de commande et la seconde électrode principale. En effet, lorsque la tension d'écrêtage de l'écrêteur est atteinte, par exemple 20 volts, celui-ci dérive le courant de commande vers la seconde électrode principale et évite ainsi toute détérioration du commutateur.

Pour rendre pleinement conducteur le commutateur, il convient de disposer sur l'électrode de commande d'une tension suffisante. Cette tension mesurée par rapport à l'électrode principale au potentiel le plus bas est généralement une tension supérieure à 10 volts environ.

Ainsi, selon un aspect de l'invention le commutateur présente préférentiellement une résistance interne adaptée au courant des impulsions, de sorte que le commutateur présente entre ses électrodes principales, c'est-à-dire les électrodes reliées dans le circuit de charge, une tension comprise entre 10 V et 50 V, lors d'une impulsion, c'est-à-dire à l'état passant. Ceci permet une commutation rapide.

Pour un courant d'impulsions compris entre 10A et 40A, la résistance interne est, par exemple, de 1 Ω.

Lorsque la tension entre les électrodes principales est supérieure à 50 V, les composants du commutateur fonctionnent généralement dans un mode linéaire et ne sont pas véritablement à l'état conducteur.

Le commutateur peut comporter un ou plusieurs transistors à grille isolée, c'est-à-dire commandés en tension. Il est possible d'utiliser des transistors à effet de champ à grille métallique isolée de type MOS par exemple (Metal-Oxyde-Semi-conductor) ou des transistors bipolaires à grille isolée du type IGBT (Insulated Gate Bipolar Transistor). La première et la seconde électrodes principales et l'électrode de commande correspondent respectivement au drain, à la source et à la grille du ou des transistors. Dans la suite du texte et par extension, on entend par drain aussi bien l'électrode principale d'un transistor de type MOS que le collecteur d'un transistor bipolaire à grille isolée (IGBT). Par source, on entend la seconde électrode principale d'un transistor MOS ou l'émetteur d'un transistor bipolaire à grille isolée (IGBT).

Parmi les transistors à effet de champ, on peut utiliser de façon préférentielle les transistors à effet de champ à canal N, c'est-à-dire dans lequel les porteurs majoritaires sont des électrons. Ainsi, le drain est relié à un potentiel supérieur à celui de la source. Selon que l'on souhaite produire des impulsions de haute tension ou de fort courant, le commutateur peut comporter une pluralité de transistors montés en parallèle ou en série. Selon un aspect de l'invention, les moyens de mise en conduction peuvent comporter une diode montée en série avec un interrupteur et connectée par son anode à la première électrode principale du commutateur. La diode empêche la décharge du condensateur de grille lorsque la tension du ou des drains des transistors devient inférieure aux tensions des grilles.

Selon un autre aspect, les moyens de mise en conduction peuvent comporter également un écrêteur monté en parallèle sur l'interrupteur afin de limiter la tension de l'électrode de commande du commutateur.

L'invention concerne aussi un commutateur d'impulsions de fort courant et de faible durée comportant une pluralité de transistors à grille isolée. Les transistors à grille isolée sont répartis en des groupes de transistors à grille isolée montés en série et/ou en parallèle, et commandés par des dispositifs de commande respectivement associés à chaque groupe, les dispositifs de commande étant conformes à l'invention.

Les groupes de transistors peuvent être reliés entre eux en parallèle et/ou en série. Il est possible également de réaliser une combinaison de groupes dont certains sont reliés en parallèle et d'autres en série. Grâce à l'invention, le dispositif de commande ne nécessite plus une source de tension autonome ni une source de tension auxiliaire telle que décrite dans ce qui précède.

Le courant de commande est directement fourni par le circuit principal qui est commandé. Ainsi, le réservoir d'énergie électrique du circuit principal qui fournit le courant nécessaire aux impulsions, fournit également le courant de commande, dont l'intensité reste très faible comparativement à celle du courant dans le circuit de charge.

### Brève description des figures

- la figure 1, déjà décrite, est une vue schématique simplifiée d'un commutateur d'impulsions et d'un dispositif de commande du commutateur conforme à l'art antérieur ;
- la figure 2 est un schéma simplifié d'un commutateur permettant d'illustrer le principe de la présente invention ;
- la figure 3 est un schéma simplifié représentant les principaux éléments du commutateur et du dispositif de commande conformes à l'invention ;
- la figure 4 est un schéma de câblage du dispositif de commande et du commutateur selon l'invention ;
- la figure 5 est un schéma de câblage d'un commutateur comportant une pluralité de transistors reliés en série et en parallèle et une pluralité de dispositifs de commande pour les transistors.

### Description détaillée de modes de mise en oeuvre de l'invention

Des éléments communs à différentes figures décrites dans la description portent les mêmes références.

Le schéma de la figure 2 représente un commutateur 2 identique à celui de la figure 1 et des moyens de mise en conduction 36 qui permettent d'illustrer le principe de l'invention. Les moyens de mise en conduction comportent de façon très simplifiée un interrupteur 38 dans un circuit qui relie la borne 12 du drain à la résistance de grille 34. Conformément au principe de l'invention, c'est le courant du circuit principal 6 qui est utilisé pour la commande du commutateur. Lorsque l'interrupteur 38 se ferme, un courant circule de la borne 12 vers la borne de grille 22 et provoque la charge du condensateur de grille 20. Le condensateur 18 se décharge sur lui-même par l'intermédiaire de l'interrupteur 38. Lorsque le transistor conduit, il permet aussi la décharge du condensateur 16.

La figure 3 est un schéma plus complet montrant les éléments fonctionnels d'un dispositif de commande conforme à l'invention. Le commutateur 2 comporte soit un seul, soit une pluralité de transistors 4 reliés en parallèle, bien que la figure n'en représente qu'un seul. Ces transistors sont du type commandés en tension, c'est-à-dire des transistors à grille isolée. Il s'agit, par exemple, de transistors du type métal-oxyde-semi-conducteur MOS, de transistors bipolaires à grille isolée du type IGBT.

Ce dispositif de commande comporte tout d'abord des moyens de mise en conduction 36 avec un interrupteur 38. L'interrupteur, par exemple un transistor à effet de champ, est commandé par un circuit de commande 36 qui sera décrit plus en détail dans la suite de la description. Le dispositif de commande comporte aussi des moyens 40 dits de décharge pour suspendre la conduction du commutateur 2. Une diode 42 est branchée entre l'interrupteur 38 et le drain 12 du commutateur 2 auquel elle est reliée par son anode. La diode 42 empêche la décharge du condensateur de grille ou des condensateurs de grille du commutateur 2 lorsque la tension de drain à la borne 12 devient inférieure à la tension de la borne 22 lors d'une impulsion dans la charge 8, la borne 22 correspondant à la grille du transistor 4 du commutateur 2.

Le dispositif de commutation comporte enfin des moyens écrêteurs 39 qui permettent de limiter la tension entre la borne 22 et la borne 14, c'est-à-dire la tension entre les grilles et les sources des transistors 4 du commutateur 2 à une valeur inférieure à la spécification du constructeur de ces composants.

Des moyens de blocage 40, décrits dans la suite de la description sont également connectés entre les bornes 22 et 14.

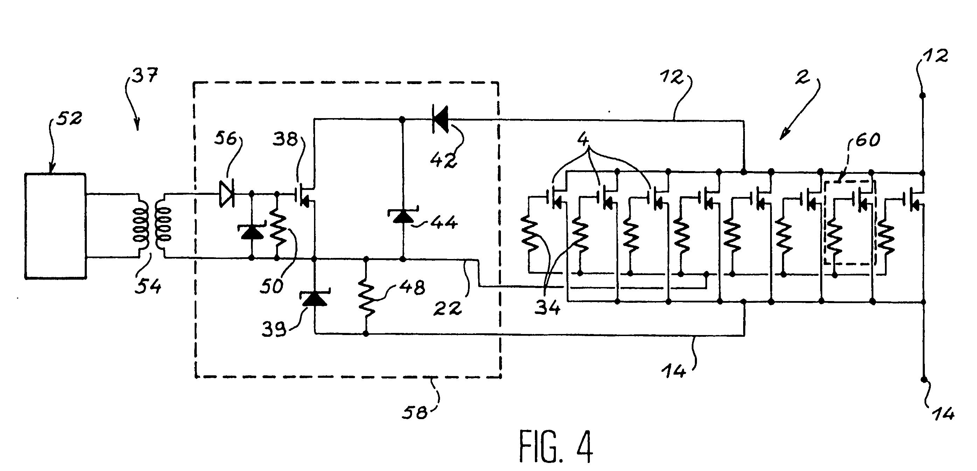

La figure 4 montre de façon plus détaillée un schéma de câblage du dispositif conforme à l'invention. On retrouve des éléments des figures précédentes et en particulier l'interrupteur 38 qui est par exemple un transistor du type IRF 840, le commutateur 2 qui comporte dans l'exemple de la figure huit transistors 4 branchés en parallèle. Les sources et les drains des transistors sont respectivement reliés entre eux et reliés aux bornes 12 et 14 du commutateur 2. L'interrupteur 38 est relié à la borne 12 par l'intermédiaire de la diode 42, et à la grille de chaque transistor 4 par l'intermédiaire respectivement d'une résistance 34. Une résistance 34 est associée à chaque transistor 4 afin d'obtenir des courants de commande distribués de façon uniforme entre les différents transistors 4.

Des diodes d'écrêtage 39, 44 sont respectivement branchées entre la grille et le drain et la source des transistors. Les moyens de blocage 40 destinés à faire passer les transistors du commutateur 2 dans un état de blocage sont, dans l'exemple de la figure, simplement réalisés avec une résistance 48 branchée en parallèle sur l'écrêteur 39, c'est-à-dire aux bornes 22 et 14 du commutateur. La résistance 48 permet de décharger le condensateur 20 et de provoquer ainsi le blocage du transistor 4. Une autre résistance 50 est branchée entre la grille et la source du transistor de l'interrupteur 38. Cette résistance permet également le blocage du transistor 38 lorsque le courant de commande a été envoyé au transistor 4. A titre d'exemple, les résistances 48 et 50 ont des valeurs respectivement de 100 Ω et de 1 KΩ. Un circuit de commande 37 comporte un étage 52 dit de basse tension qui fournit des ordres de commande à l'interrupteur 38 par l'intermédiaire d'un transformateur d'impulsions 54 et une diode 56 dont la cathode est reliée à la grille 22 du transistor de l'interrupteur 38.

Le transformateur d'impulsions 54 comporte par exemple un tore (muni d'un bobinage et) traversé par un câble de haute tension qui constitue l'étage primaire du transformateur. Le bobinage du tore constitue le secondaire. Le transformateur permet de réaliser une isolation galvanique entre le commutateur 2 et l'étage de basse tension 52. Finalement, sur la figure 4, on peut distinguer globalement trois parties, d'une part l'étage de basse tension 52 avec le transformateur d'impulsions 54, puis un étage qui comporte l'interrupteur 38 et enfin un étage formé par le commutateur 2. Le deuxième étage qui comporte l'interrupteur 38 est désigné dans la suite de la description par îlot et porte la référence 58. On désigne par îlot l'ensemble des composants qui réalise le dispositif de commande pour un commutateur comprenant un ou plusieurs transistors à grille isolée 4. Des bornes de l'îlot 58 portant les références 58i, 58j, 58g, 58s et 58d correspondent respectivement aux connexions au transformateur 54, et aux grilles, sources et drain.

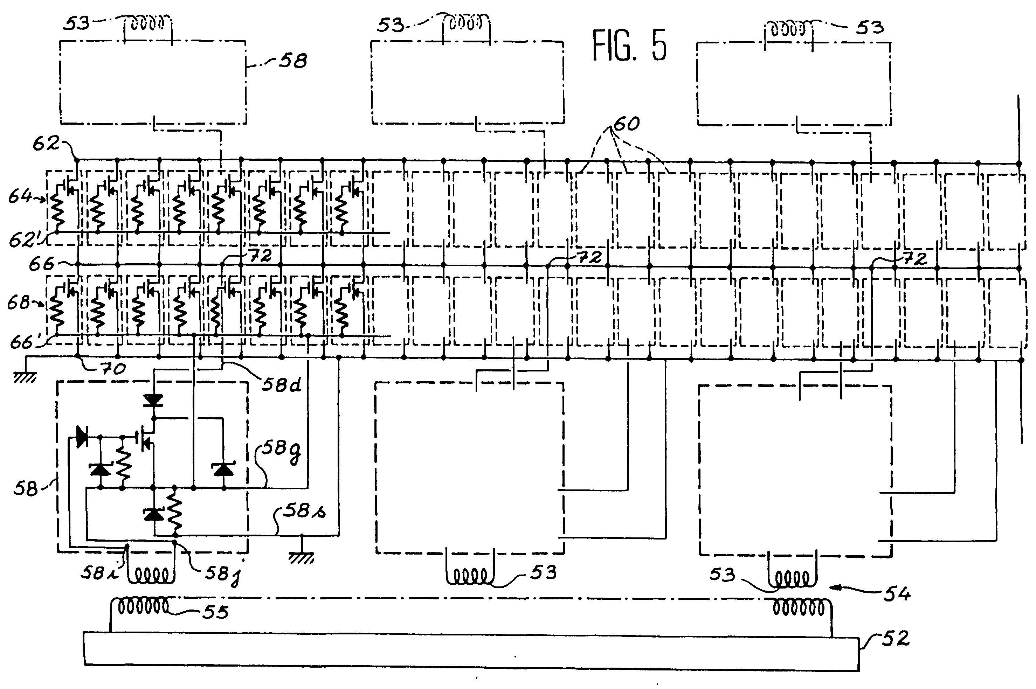

De la même façon et pour des raisons de clarté, sur la figure 5 qui donne un exemple de câblage de commutateur comportant un grand nombre de transistors, des blocs de référence 60 représentent chaque fois un transistor 4 associé à une résistance 34 reliée à la grille du transistor. Les blocs 60 sont simplement désignés dans la suite de la description par transistors 60.

La figure 5 donne un modèle de câblage qui s'applique particulièrement bien pour une implantation des transistors sur un circuit imprimé sous forme d'une matrice. Dans cette matrice, les lignes sont constituées par des transistors à grille isolée montés en parallèle, tandis que les colonnes sont constituées par des transistors mis en série.

Dans l'exemple de la figure 5, le montage comporte deux lignes, la ligne 62 correspondant à un premier groupe 64 de vingt-quatre transistors 60 montés en parallèle. L'ensemble des transistors du groupe 64 ont leurs drains reliés à la ligne 62. Une ligne de commande 62' est reliée respectivement à chaque grille des transistors 60. L'ensemble des sources respectivement de chaque transistor 60 du groupe 64 sont reliés entre eux et également à une ligne 66 à laquelle sont également connectés tous les drains d'un second groupe 68 de transistors 60. De même que pour le premier groupe, les transistors du groupe 68 ont leurs grilles reliées à une ligne de commande 66' et leurs sources reliées respectivement à une ligne 70.

Dans le cas présent, les groupes 64 et 68 de transistors sont reliés en série. La ligne 62 est par exemple reliée à une source de haute tension ou à un réservoir d'énergie électrique susceptible de fournir des impulsions de fort courant et la ligne 70 est reliée à la masse. Dans d'autres applications, il est bien sur possible de mettre en série un nombre de groupes de transistors plus important. Pour la commande des quarante-huit transistors, des groupes 64 et 68, le montage comporte six îlots 58, c'est-à-dire six dispositifs de commande. Les sorties 58d, 58g et 58s de chaque îlot sont respectivement reliées à des lignes correspondant aux drains, aux grilles et aux sources des transistors 60. Les sorties 58d sont reliées de telle manière aux lignes 66 et 62 que de part et d'autre des connexions de la sortie 58d sur cette ligne, se trouvent chaque fois quatre transistors. Ainsi, chaque îlot est destiné à la commande de huit transistors connectés respectivement de part et d'autre de la connexion 72 des sorties 58d respectivement sur les lignes 66 et 62.

On peut ainsi définir dans les groupes 64 et 68 des sous-groupes de huit transistors en parallèle associés chaque fois à un îlot de commande. Cette répartition des transistors sur différents îlots de commande bien que l'ensemble des transistors soit relié en parallèle, permet une bonne distribution des courants de commande et donc une commande simultanée de l'ensemble des transistors. Les sorties 58i et 58j des îlots 58 sont respectivement reliées à des enroulements secondaires 53 d'un transformateur 54 dont l'enroulement primaire 55 est relié à l'étage de basse tension 52. Pour des raisons de clarté de la figure, certains enroulements secondaires 53 (en trait mixte) du transformateur 54 ne sont pas représentés en face de l'enroulement primaire 55 relié à 52. Ces enroulements 53 font toutefois partie du transformateur 54 et coopèrent avec l'enroulement primaire 55.

Dans le cas de la figure, le courant de commande peut atteindre 72A. Grâce à l'utilisation d'îlots et de dispositifs de commande conformes à l'invention, il est possible avec un nombre de composants très limité de fournir le courant nécessaire. Des connexions de drain et de source en cuivre s'étendant sur toute la largeur du circuit imprimé permettent en outre, grâce à l'invention, de minimiser les inductions parasites et provoquer la commutation synchrone de tous les transistors à grille isolée.

## Revendications

1. Dispositif de commande d'un commutateur (2) à grille isolée ayant une première électrode principale (12) et une seconde électrode principale (14) destinées à être reliées à un circuit dit de charge (6), en vue de la commutation d'impulsions de fort courant, le dispositif de commande comportant des moyens dits de blocage (40) du commutateur, des moyens de mise en conduction (36) du commutateur, **caractérisé en ce que** les moyens de mise en conduction comportent un écrêteur (39) pour limiter la tension d'une électrode de commande (22) du commutateur, et un circuit de commande d'un courant circulant du circuit de charge (6) vers l'électrode de commande (22) et rendant le commutateur (2) pleinement conducteur, le circuit de commande comportant au moins un interrupteur (38) connecté entre l'électrode de commande (22) et la première électrode principale (12), la première électrode principale (12) devant être portée à un potentiel supérieur à celui de la seconde électrode principale (14) lors de la liaison au circuit de charge (6).

2. Dispositif selon la revendication 1, **caractérisé en ce que** l'interrupteur (38) est un transistor à effet de champ.

3. Dispositif selon l'une quelconque des revendications 1 ou 2, **caractérisé en ce que** les moyens de mise en conduction comportent une diode (42) montée en série avec l'interrupteur (38) et connectée par son anode à la première électrode principale (12) du commutateur.

4. Dispositif selon l'une des revendications 1 ou 2, **caractérisé en ce que** les moyens de mise en conduction comportent un écrêteur (44) monté en parallèle sur l'interrupteur pour limiter la tension de l'électrode de commande.

5. Ensemble formé du dispositif de commande selon l'une quelconque des revendications 1 à 4 et du commutateur à grille isolée, **caractérisé en ce que** le commutateur présente une résistance interne adaptée au courant des impulsions, de sorte que le commutateur (2) présente, entre les électrodes principales (12, 14), lorsqu'elles sont reliées au circuit de charge (6), une tension d'impulsion comprise entre 10 et 50 V.

6. Ensemble formé, d'un dispositif de commande selon l'une des revendications 1 à 4, et du commutateur à grille isolée, **caractérisé en ce que** le commutateur (2) comporte au moins un transistor à grille isolée (4), la première et la seconde électrodes (12, 14), et l'électrode de commande (22) correspondant respectivement au drain, à la source et à la grille du transistor.

7. Ensemble selon la revendication 6, **caractérisé en ce que** le transistor à grille isolée (4) est choisi dans le groupe consistant en les transistors de type MOS et les transistors de type IGBT.

8. Ensemble selon la revendication 6, **caractérisé en ce que** le commutateur (2) comporte une pluralité de transistors (4) montés en parallèle et/ou en série, la première électrode (12), la seconde électrode (14) et l'électrode commande (22) étant respectivement reliées aux drain, source et grille de chaque transistor.

9. Commutateur d'impulsions de fort courant comportant une pluralité de transistors à grille isolée (4), **caractérisé en ce que** les transistors à grille isolée (4) sont répartis en des groupes de transistors à grille isolée montés en série et/ou en parallèle, et commandés par des dispositifs de commande (58) respectivement associés à chaque groupe, les dispositifs de commande étant conformes à l'une quelconque des revendications 1 à 4.

## Patentansprüche

1. Ansteuerungsvorrichtung eines Insulated-Gate-Schalters (2) mit einer ersten Hauptelektrode (12) und einer zweiten Hauptelektrode (14), dazu bestimmt, hinsichtlich der Schaltung von Starkstromimpulsen mit einem sogenannten Ladekreis (6) verbunden zu werden, wobei die Ansteuerungsvorrichtung sogenannte Blockierungseinrichtungen (40) des Schalters und Leitungseinrichtungen (36) des Schalters umfasst,
**dadurch gekennzeichnet, dass** die Leitungseinrichtungen einen Strombegrenzer (39) umfassen, um die Spannung einer Steuerelektrode (22) des Schalters zu begrenzen, und eine Steuerschaltung eines Stroms, der von dem Ladekreis (6) zu der Steuerelektrode (22) fließt und den Schalter (2) vollkommen leitend macht, wobei die Steuerschaltung wenigstens einen Unterbrechungsschalter (38) umfasst, vorgesehen zwischen der Steuerelektrode (22) und der ersten Hauptelektrode (12), und die erste Hauptelektrode (12) auf ein Potential gebracht werden muss, das höher ist als das der zweiten Hauptelektrode (14) während der Verbindung mit dem Ladekreis (6).

2. Vorrichtung nach Anspruch 1, **dadurch gekennzeichnet, dass** der Unterbrechungsschalter (38) ein Feldeffekttransistor ist.

3. Vorrichtung nach einem der Ansprüche 1 oder 2, **dadurch gekennzeichnet, dass** die Leitungseinrichtungen eine mit dem Unterbrechungsschalter (38) seriengeschaltete und mit ihrer Anode mit der ersten Hauptelektrode (12) verbundene Diode (42) umfassen.

4. Vorrichtung nach einem der Ansprüche 1 oder 2, **dadurch gekennzeichnet, dass** die Leitungseinrichtungen einen zu dem Unterbrechungsschalter parallelgeschalteten Strombegrenzer (44) umfassen, um die Spannung der Steuerelektrode zu begrenzen.

5. Einheit, gebildet durch die Ansteuerungsvorrichtung nach einem der Ansprüche 1 bis 4 und den Insulated-Gate-Schalter, **dadurch gekennzeichnet, dass** der Schalter einen derart an den Strom der Impulse angepassten internen Widerstand aufweist, dass der Schalter (2) zwischen den Hauptelektroden (12, 14), wenn sie mit der Ladeschaltung (6) verbunden sind, eine zwischen 10 und 50 V enthaltene Spannung aufweist.

6. Einheit, gebildet durch die Ansteuerungsvorrichtung nach einem der Ansprüche 1 bis 4 und den Insulated-Gate-Schalter, **dadurch gekennzeichnet, dass** der Schalter (2) wenigstens einen Insulated-Gate-Transistor (4) umfasst, wobei die erste und die zweite Elektrode (12, 14) und die Steuerelektrode (22) jeweils dem Drain, der Source und dem Gate des Transistors entsprechen.

7. Einheit nach Anspruch 6, **dadurch gekennzeichnet, dass** der Insulated-Gate-Transistor (4) ausgewählt wird aus der Gruppe, welche die Transistoren des MOS-Typs und die Transistoren des IGBT-Typs umfasst.

8. Einheit nach Anspruch 6, **dadurch gekennzeichnet, dass** der Schalter (2) eine Vielzahl parallel- und/oder seriellgeschalteter Transistoren umfasst, wobei die erste Elektrode (12), die zweite Elektrode (14) und die Steuerelektrode (22) jeweils mit Drain, Source und Gate jedes Transistors verbunden sind.

9. Hochstromimpulsschalter mit einer Vielzahl Insulated-Gate-Transistoren (4), **dadurch gekennzeichnet, dass** die Insulated-Gate-Transistoren (4) auf serien- oder parallelgeschaltete Insulated-Gate-Transistorengruppen verteilt sind und durch jeweils mit jeder Gruppe verbundene Ansteuerungsvorrichtungen (58) gesteuert werden, wobei die Ansteuerungsvorrichtungen einem der Ansprüche 1 bis 4 entsprechen.

## Claims

1. Device for controlling an insulated-gate switch (2) having a first main electrode (12) and a second main electrode (14) that are intended to be connected to what is called a load circuit (6), for the purpose of switching high-current pulses, the control device including what are called turn-off means (40) for turning the switch off and turn-on means (36) for turning the switch on, **characterized in that** the turn-on means include a clipper (39) for limiting the voltage of a control electrode (22) of the switch, and a circuit for controlling a current flowing from the load circuit (6) into the control electrode (22) and making the switch (2) fully conducting, the control circuit including at least one switch (38) connected between the control electrode (22) and the first main electrode (12), the first main electrode (12) having to be raised to a potential above that of the second main electrode (14) upon connection to the load circuit (6).

2. Device according to Claim 1, **characterized in that** the switch (38) is a field-effect transistor.

3. Device according to either of Claims 1 and 2, **characterized in that** the turn-on means comprise a diode (42) connected in series with the switch (38) and connected via its anode to the first main electrode (12) of the switch.

4. Device according to either of Claims 1 and 2, **characterized in that** the turn-on means include a clipper (44) connected in parallel with the switch in order to limit the voltage of the control electrode.

5. Assembly formed from the control device according to any one of Claims 1 to 4 and from the insulated-gate switch, **characterized in that** the switch has an internal resistance matched to the current of the pulses, so that the switch (2) has, between the main electrodes (12, 14), a pulse voltage of between 10 and 50 V when the electrodes are connected to the load circuit (6).

6. Assembly formed from a control device according to one of Claims 1 to 4, and from the insulated-gate switch, **characterized in that** the switch (2) comprises at least one insulated-gate transistor (4), the first and second electrodes (12, 14) and the control electrode (22) corresponding to the drain, to the source and to the gate of the transistor, respectively.

7. Assembly according to Claim 6, **characterized in that** the insulated-gate transistor (4) is chosen from the group consisting of MOS transistors and IGBT transistors.

8. Assembly according to Claim 6, **characterized in that** the switch (2) comprises a plurality of transistors (4) connected in parallel and/or in series, the first electrode (12), the second electrode (14) and the control electrode (22) being connected to the drain, source and gate of each transistor, respectively.

9. High-current pulse switch, comprising a plurality of insulated-gate transistors (4), **characterized in that** the insulated-gate transistors (4) are divided into groups of insulated-gate transistors connected in series and/or in parallel, and controlled by control devices (58) associated with each respective group, the control devices being in accordance with any one of Claims 1 to 4.
